**Europäisches Patentamt**

**European Patent Office**

**Office européen des brevets**

(11) Veröffentlichungsnummer : **0 100 997**
**B1**

(12) # EUROPÄISCHE PATENTSCHRIFT

(45) Veröffentlichungstag der Patentschrift :
01.02.89

(51) Int. Cl.⁴ : **H 03 H   9/145**, H 03 H   9/64,
H 03 H   9/44

(21) Anmeldenummer : **83107618.7**

(22) Anmeldetag : **02.08.83**

(54) **Mit reflektierten akustischen Wellen arbeitendes elektronisches Bauelement.**

(30) Priorität : **12.08.82 DE 3230038**

(43) Veröffentlichungstag der Anmeldung :
**22.02.84 Patentblatt 84/08**

(45) Bekanntmachung des Hinweises auf die Patenterteilung : **01.02.89 Patentblatt 89/05**

(84) Benannte Vertragsstaaten :
**DE FR GB**

(56) Entgegenhaltungen :
**GB—A— 2 030 411**

(73) Patentinhaber : **Siemens Aktiengesellschaft Berlin
und München
Wittelsbacherplatz 2
D-8000 München 2 (DE)**

(72) Erfinder : **Riha, Gerd, Dr.
Kameruner Strasse 20
D-8000 München 82 (DE)**

**Beschreibung**

Die vorliegende Erfindung bezieht sich auf ein elektronisches Bauelement, wie es im Oberbegriff des Patentanspruches 1 angegeben ist.

In den europäischen Patentanmeldungen EP-82 104 727 veröffentlicht am 8.12.1982 unter EP-A-0 066 281 und EP-83 102 608-3 veröffentlicht am 28.9.83 unter EP-A-0 089 617 sind Oberflächenwellenfilter nach Art einer dispersiven Verzögerungsleitung und eine Verbesserung zu einem solchen Filter beschrieben. Insbesondere bei der an zweiter Stelle genannten Anmeldung handelt es sich um ein mit akustischen Wellen arbeitendes elektronisches Bauelement, bei dem die zum Erreichen einer bestimmten vorgegebenen Übertragungsfunktion vorgesehene Fingerwichtung dadurch realisiert ist, daß die Abstände von Fingergruppen voneinander und insbesondere einzelner Finger voneinander gegenüber einer solchen Lage der Finger verändert ist, die einem solchen Bauelement ohne Fingerwichtung entsprechen würde. In der an erster Stelle genannten Patentanmeldung ist diese Fingerwichtung durch dem Prinzip nach an sich vorbekannte Fingerlängen-Wichtung realisiert und die bei diesem Bauelement vorgesehenen nicht äquidistanten Abstände von Fingern oder Fingergruppen voneinander dienen dem Erreichen einer vorgegebenen Dispersion dieses Bauelementes.

Die Erfindung der Anmeldung EP-83 102 608-3 bietet den Vorzug, (abgesehen von einer in diesem Bauelement realisierten Dispersion) die für die vorgegebene Amplitudenfunktion der Übertragungscharakteristik notwendige Fingerwichtung so auszuführen, daß sich die aktiven Anteile der einzelnen Finger der jeweils verwendeten Digitalstruktur(-en) über die gesamte Breite des Arbeitsbereichs dieses elektronischen Bauelementes, das heißt über die gesamte Breite der Struktur(-en) quer zur Hauptausbreitungsrichtung der akustischen Welle erstrecken. Damit hat man störende Nebeneffekte trotz Vorliegens einer Fingerwichtung vermeiden können, die mit Fingerlängen-gewichteten Strukturen oder mit Fingerdotsgewichteten Strukturen verbunden sind.

Im Extremum kann bei einem elektronischen Bauelement nach der Anmeldung EP-83 102 608-3 eine die notwendige Fingerwichtung realisierende (auf eine nicht gewichtete Struktur bezogen) Verschiebung jeweils benachbarter Finger gegeneinander vorgesehen sein, das heißt, eine jeweilige, der Fingerwichtung zu unterwerfende Fingergruppe besteht aus nur zwei Fingern. Es wird damit für eine Struktur bzw. für ein Bauelement nach dieser älteren Erfindung maximale Bandbreite erzielt.

Aus der GB-A-2 030 411, insbesondere Seite 1, Zeilen 82 bis 106 geht ein Oberflächenwellenfilter hervor, das zwei dispersive Reflektorstrukturen hat, die über einen Multistripkoppler miteinander und mit Eingang und Ausgang gekoppelt sind. Es sind dort Maßnahmen getroffen, die Anteile der zwei reflektierten Signale der Reflektorstrukturen in 180° Phasenunterschied zueinander bringen. Diese Signalaufhebung resultiert in einer Null-Amplitude für diese Signalanteile. Zwischenliegende Phasenverschiebungen der Reflektorfinger der Reflektorstrukturen führen zu Signalen mit Amplituden-Zwischenwerten. Diese Beeinflussung des Signals des Filters durch Verschiebung der Position von Reflektorfingern der einen Reflektorstruktur gegenüber der Position entsprechender Reflektorfinger der anderen Reflektorstruktur beruht auf dem Vorhandensein des Multistrip-Kopplers dieses bekannten Filters.

Dieses bekannte Filter hat den Nachteil, daß die für die Signalwichtung erforderliche Interferenz der durch die zweite Reflektorstruktur reflektierten Wellen außerhalb der Reflektorstrukturen, nämlich in dem Multistrip-Koppler erfolgt. Dies bedingt Verluste an Signalenergie für die Reflektorstrukturen.

Außerdem treten bei dem bekannten Filter zusätzliche Störungen durch Reflexionen auf, die auf mehrfachem Hin- und Herlaufen der einzelnen reflektierten Signale zwischen Multistrip-Koppler, Wandler und jeweiliger Reflektorstruktur beruhen.

Ein wie aus der GB-A bekanntes Filter läßt sich im übrigen sinnvoll nur bei Verwendung elektromechanisch stark koppelnder Substratmaterialien, z. B. Lithiumniobat, verwenden. Dieses Material hat aber ein schlechtes Temperaturverhalten z. B. vergleichsweise zu Quarz, einem nur schwach koppelnden Substratmaterial.

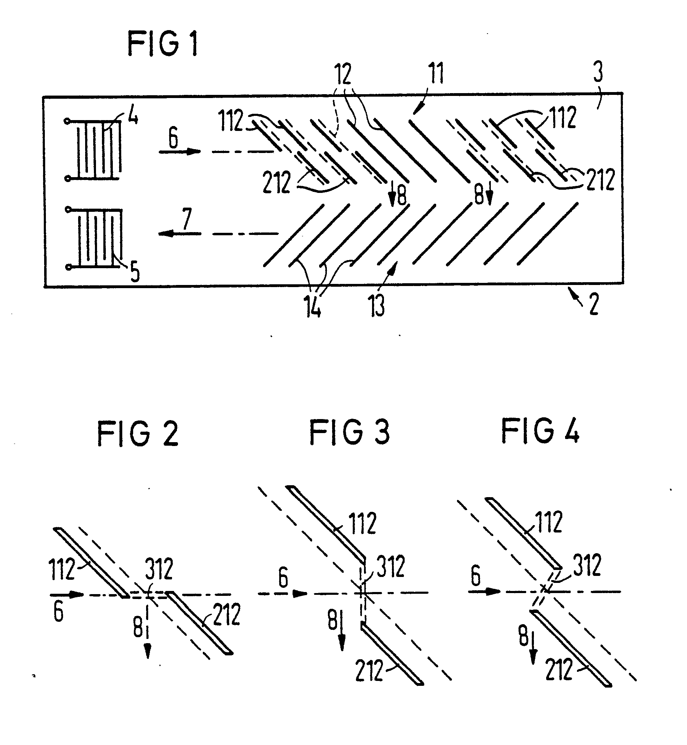

Die Fig. 3 und 4 dieser GB-A zeigen noch eine zweite, aber andere Maßnahme für das bekannte Filter. Bei diesem bekannten Filter sollen bestimmte Frequenzbereiche mehr oder weniger ausgelöscht werden, indem man einzelne Reflektorfinger dieser Frequenzbereiche der dispersiven Reflektorstruktur verkürzt, d. h. für Signalreflektion mehr oder weniger unwirksam macht. Die Reflektorfinger sind dazu geteilt und der abgeteilte Fingeranteil ist gegenphasig positioniert. Dies ist prinzipiell eine Fingerlängen-Amplitudenwichtung, wie sie von interdigitalen Wandlern her bekannt ist. Der abgetrennte 180°-phasenverschobene Fingeranteil des jeweiligen Reflektorfingers der Reflektorstruktur des bekannten Filters könnte dort auch weggelassen sein, wozu dann nur eine Korrektur der Länge des verbleibenden Teilfingers erforderlich wäre. Um möglichst gleichmäßige akustische Bedingungen für die Wellenausbreitung in der Struktur zu haben, vermeidet man eine Weglassung von Fingeranteilen, weshalb z. B. bei Interdigital-Wandlern dummy-Finger verwendet werden, was aber bei einem Reflektor in entsprechender Weise nicht zum Erfolg führen würde. Dort hilft die Phasenverschiebung 180°.

Es ist also Aufgabe der vorliegenden Erfindung, für ein mit reflektierten akustischen Wellen arbeitendes elektronisches Bauelement eine Fingerwichtung anzugeben, die (ebenso wie die Fingerwichtung nach der älteren Erfindung der Anmeldung EP-83 102 608-3, veröffentlicht am 28.9.83 unter der Nummer EP-A-0 089 617 frei von störenden Nebeneffekten (mehrfache Reflexionen, Signalverlust in der Reflexions-Digitalstruktur) ist, die aber dennoch (vergleichsweise zu einem Bauelement ohne Fingerwichtung) größtmögliche bzw. der älteren Erfindung gegenüber noch größere Bandbreite zuläßt.

Für ein elektronisches Bauelement nach dem Oberbegriff des Patentanspruches 1 wird diese Aufgabe erfindungsgemäß mit den zusätzlichen Merkmalen des Kennzeichens des Patentanspruches 1 gelöst und weitere Ausgestaltungen und Weiterbildungen der Erfindung gehen aus den Unteransprüchen hervor.

Der vorliegenden Erfindung liegt die Überlegung zugrunde, daß gegenüber der älteren Erfindung noch größere Bandbreite der jeweiligen Digitalstruktur bzw. des ganzen Bauelementes nur dadurch zu erreichen ist, daß ein vergleichsweise anderer Lösungsweg beschritten wir. Für diesen Lösungsweg kann von einem bekannten mit akustischen Wellen arbeitenden, elektronischen Bauelement und zum Beispiel auch von einem Bauelement der älteren Anmeldung EP-82 104 727-1 das zur Realisierung einer Dispersion variierte Fingerabstände aufweist, ausgegangen werden.

Der hier vorliegenden Erfindung liegt der Gedanke zugrunde, eine « Fingerverschiebung » so auszuführen, daß sie sich als Fingerwichtung bereits auf den bzw. in dem jeweils einzelnen Finger auswirkt. Das hier zugrundeliegende Lösungsprinzip besteht darin, den jeweiligen einzelnen, einer Fingerwichtung zu unterwerfenden Finger einer betreffenden Struktur des elektronischen Bauelements in seiner Längsrichtung wenigstens einmal zu unterteilen und die mindestens zwei entstehenden Teile parallel zur Haupt-Wellenausbreitungsrichtung gegeneinander versetzt anzuordnen. Die Haupt-Wellenausbreitungsrichtung ist die Richtung, in der die akustische Welle vorgesehenerweise in dem elektronischen Bauelement verläuft. Bei einem Bauelement mit von 180° verschiedener Wellenreflexion, zum Beispiel mit $2 \times 90°$ Wellenreflexion (mit im Winkel von 45° schräggestellten Reflexionsfingern) liegt dann eine Haupt-Wellenausbreitungsrichtung vor, die in Hinrichtung und parallel dazu in Rückrichtung durchlaufen wird und eine weitere Haupt-Wellenausbreitungsrichtung vor die quer dazu verläuft. Bei einer solchen Ausführung des elektronischen Bauelements kann das Versetzen der Fingerteile parallel zur einen Haupt-Wellenausbreitungsrichtung oder zur anderen Haupt-Wellenausbreitungsrichtung oder auch teilweise zur einen und teilweise zur anderen Haupt-Wellenausbreitungsrichtung realisiert sein. Die im Zusammenhang mit der Teilung der einzelnen Finger erwähnte Längsrichtung derselben ist die Richtung der größten geometrischen Abmessung der einzelnen Finger. Bei dem Bauelement mit abgeknicktem Weg der Wellenausbreitung der akustischen Welle verläuft diese Längsrichtung der betreffenden Finger bei zum Beispiel 90°-Reflexion im Bauelement im Regelfall im Winkel von 45° zur einen und zur anderen Haupt-Wellenausbreitungsrichtung (homogene bzw. isotrope Verhältnisse angenommen).

Weitere Erläuterungen der Erfindung gehen aus der nachfolgenden anhand der Figuren gegebenen Beschreibung zu Ausführungsbeispielen der Erfindung hervor.

Figur 1 zeigt eine prinzipielle Ausführungsform eines mit reflektierten akustischen Wellen arbeitenden elektronischen Bauelementes mit Wellenreflexion in von 180° verschiedenem Winkel. Die dargestellten Strukturen bzw. die vorhandenen Elektrodenfinger sind vorzugsweise Metallisierungsstreifen, die sich auf der in der Figur 1 oberen Oberfläche 3 des Substratkörpers 2 befinden. Mit 4 und 5 sind zwei an sich bekannte Interdigital-Wandlerstrukturen bezeichnet. In der einen Struktur wird aus dem elektrischen Eingangssignal eine akustischen Oberflächenwelle in dem piezoelektrischen Material der Oberfläche 3 des Substratkörpers 2 erzeugt. Mit dem anderen dieser Wandler kann aus der empfangenen akustischen Welle ein elektrisches Signal zurückgewonnen werden. Elektrisches Eingangssignal und Ausgangssignal unterscheiden sich entsprechend der für dieses Bauelement vorgegebenen Übertragungsfunktion.

Beim Beispiel der Figur 1 ist der Wandler 4 als Eingang und der Wandler 5 als Ausgang angenommen, so daß sich Haupt-Wellenausbreitungsrichtungen ergeben, die durch die Pfeile 6, 7 und 8 angedeutet sind. Die somit in der Richtung des Pfeiles 6 laufende akustische Welle trifft auf eine erste Reflexions-Digitalstruktur 11, die aus einer Vielzahl von in an sich bekannter Weise schräggestellten Reflexionsfingern 12 besteht. Nach der an diesen Fingern 12 erfolgten Reflexion in Richtung des Pfeiles 8 trifft die akustische Welle auf die dargestellte zweite Reflexions-Digitalstruktur, die aus einer Vielzahl wiederum schräggestellter Reflektorfinger 14 besteht. Nach an dieser Struktur 13 erfolgter Reflexion verläuft die Well bzw. ist die Haupt-Wellenausbreitungsrichtung parallel der Richtung des Pfeiles 7.

Die jeweilige Länge einer Reflexions-Digitalstruktur 11, 13 richtet sich in an sich bekannter Weise nach den vorgegebenen Anforderungen, die an das betreffende elektronische Bauelement gestellt werden.

In der Figur 1 enthält die Reflexions-Digitalstruktur 11 eine Fingerwichtung, mit der die vorgegebene Übertragungsfunktion des Bauelements im Hinblick auf die Amplitudenfunktion erfüllt wird. Etwaige notwendige Dispersionseigenschaft kann bei einem Bauelement nach Figur 1 durch nicht-äquidistante Abstände einzelner Finger oder von Fingergruppen gegeneinander realisiert sein, wobei sich die diesbezüglich angesprochenen Abstände auf eine Lage der einzelnen Finger einer Digitalstruktur bezieht, die keine Dispersion (und auch keine Fingerwichtung durch Fingerverschiebung gemäß der älteren Erfindung) hat. Bei dem Beispiel der Figur 1 ist eine solche nicht dispersive, nicht gewichtete Reflexions-Digitalstruktur mit der Struktur 13 wiedergegeben. Es sei aber darauf hingewiesen, daß bei diesem Beispiel der Figur 1 auch der Struktur 13 dispersive und/oder gewichtete Eigenschaft durch Querverschiebung gegeneinander gegeben sein könnte.

In Figur 1 sind diejenigen Elektrodenfinger 12, die eine entsprechende Wichtung aufweisen müssen, einmal in ihrer Länge unterteilt, so daß sich jeweils zwei Teilfinger 112, 212 ergeben. Diese beiden Teilfinger sind gegeneinander um das sich aus der geforderten Wichtung ergebende Maß verschoben, und zwar in Figur 1 parallel der Haupt-Wellenausbreitungsrichtung 6. Wie für Fingerwichtung üblich, verteilt sich diese Fingerwichtung nach Art einer Modulation auf die gesamte (mit Fingerwichtung versehene) Reflexions-Digitalstruktur 11. Für eine Verschiebung der Teilfinger 112 und 212 gegeneinander um das Maß $\lambda/2$ ergibt sich eine Fingerwichtung einer Nullstelle (die bei bekannter Überlappungswichtung einer Überlappung «Null» entsprechen würde). Ein Versatz der beiden Fingerteile 112 und 212 in der Größe «Null», das heißt so wie sie bei den Fingern 12 in der Mitte der Struktur 11 vorliegt, entspricht einem Übertragungsmaximum (bzw. vollständigem-Überlappen). Zwischenwerte des Versatzes der Fingerteile 112, 212 gegeneinander ergeben durch weniger starke Interferenz die entsprechenden Zwischenwerte einer Fingerwichtung zwischen Übertragungsmaximum und -minimum. Es sei hier darauf hingewiesen, daß für den Versatz jeweils die Komponente parallel zur betreffenden Haupt-Wellenausbreitungsrichtung (hier Richtung des Pfeiles 6) maßgeblich ist. Beim Ausführungsbeispiel der Figur 1 ist dies somit wegen der Schräglage der Finger 12 die Projektion auf die Richtung des Pfeiles 6.

Die Figuren 2, 3 und 4 zeigen nebeneinander für einen Finger (zum Beispiel für einen Finger 12) eines Bauelementes mit schräggerichteter Reflexions-Digitalstruktur drei Möglichkeiten der erfindungsgemäßen Fingerwichtungs-Versatzes, nämlich Figur 2 (wie schon in Figur 1) den Versatz parallel zur Richtung des Pfeiles 6, Figur 3 den Versatz (allein) in Richtung parallel zur Richtung des Pfeiles 8 und Figur 4 einen Versatz teilweise parallel zur Richtung des Pfeiles 6 (oder 7) und teilweise parallel zur Richtung des Pfeiles 8. Insbesondere die der Figur 2 entsprechende Maßnahme ist geeignet denkbare Störungen zu minimieren, weil in Laufrichtung der Welle für diese kein Abstand zwischen den Teilfingern 112, 212 erscheint. Zu den Figuren 2 bis 4 sei darauf hingewiesen, daß sie wesentlich vergrößerte Ausschnitte vergleichsweise zur Größenordnung der Figur 1 sind.

Wie schon oben angedeutet, kann auch die andere Reflexions-Digitalstruktur 13 (anstelle der Reflexions-Digitalstruktur 12 die (voranstehend zur Struktur 11 beeschriebene) erfindungsgemäße Fingerwichtung haben. Es kann die notwendige Fingerwichtung auch auf beiden Reflexions-Digitalstrukturen 11, 13 verteilt sein. Damit kann zum Beispiel erreicht werden, daß der notwendige Fingerversatz entsprechend aufgeteilt kleiner ist.

Es sei darauf hingewiesen, daß ein einzelner jeweiliger Finger in seiner Länge auch in mehr als nur zwei Fingerteile 112, 212 aufgeteilt sein kann. Eine mehrfache Unterteilung eines jeweiligen Fingers in Längsrichtung läßt eine Verfeinerung der betreffenden Struktur erreichen, jedoch unter Inkaufnahme entsprechenden zusätzlichen technologischen Aufwandes.

Es sei noch darauf hingewiesen, daß die zu einem Finger 12 gehörenden Teilfinger 112, 212 miteinander verbunden (312) sei können, wie dies in den Figuren 2 bis 4 gestrichelt angedeutet ist. Störungen durch eine solche Verbindung 312 sind im allgemeinen vernachlässigbar, da die jeweiligen Abstände zwischen den benachbarten Enden der jeweiligen Teilfinger 112, 212 bzw. die Längen der einzelnen Verbindungen um eine oder mehrere Größenanordnungen kleiner sind als die Länge der Finger 12 bzw. Teilfinger 112, 212. Es können damit technologische Vorteile für die Herstellung der Struktur erreicht werden.

## Patentansprüche

1. Oberflächenwellenfilter mit Fingerwichtung mit zwei Reflexions-Digitalstrukturen (11, 12) und mit einer Anzahl in ihrer Längsrichtung in Teilfinger (112, 212) geteilten Reflexionsfingern, wobei jeweils ein Teilfinger (212) eines jeweiligen geteilten Reflexionsfingers (12) bezogen auf eine Hauptwellenausbreitungsrichtung gegenüber der nicht gewichteten Position (12) verschoben ist, gekennzeichnet dadurch, daß die Reflexions-Digitalstrukturen (11, 12) zur jeweiligen Haupt-Wellenausbreitungsrichtung (6) derart schräg gestellte Reflexionsfinger (12, 13, 14, 112, 212) haben, so daß sich ein abgeknickter Weg (6, 7, 8) der Wellenausbreitung zwischen Eingang und Ausgang (4, 5) ergibt (Fig. 1), daß die Teilung eines jeweiligen zu wichtenden Fingers (12) mindestens einmal vorliegt und daß diese Teilfinger (112, 212) durch, bezogen auf die für die Wichtungsverschiebung vorgegebene Hauptwellenausbreitungsrichtung (6), jeweils entgegengesetzte Parallelverlagerung gegenüber ihrer ungewichteten Position (12) gegeneinander um das der vorgegebenen Wichtung des jeweiligen Fingers entsprechende Maß versetzt angeordnet sind.

2. Bauelement nach Anspruch 1, gekennzeichnet dadurch, daß der der Wichtung entsprechende Versatz parallel zu derjenigen Haupt-Wellenausbreitungsrichtung (6) ist, die vor der Wellenreflexion am betreffenden gewichteten Finger (12) vorliegt (Figur 1 und 2).

3. Bauelement nach Anspruch 1, gekennzeichnet dadurch, daß der der Wichtung entsprechende Versatz parallel der Haupt-Wellenausbreitungsrichtung (8) ist, die nach der Wellenreflexion am jeweiligen Finger (12) vorliegt (Figur 3).

4. Bauelement nach Anspruch 1, gekennzeichnet dadurch, daß der der Wichtung entsprechende Versatz teilweise parallel derjenigen Haupt- Wellenausbreitungsrichtung (6) ist, die vor der Wellenreflexion am betreffenden Finger (12) vorliegt und teilweise parallel der Haupt-Wellenausbreitungsrichtung (8) ist, die nach der Wellenreflexion am betreffenden Finger (12) vorliegt (Figur 4).

5. Bauelement nach einem der Ansprüche 1 bis 4, gekennzeichnet dadurch, daß die benachbarten Enden der Teilfinger 112, 212 einzelner gewichteter Finger 12 miteinander verbunden (312) sind.

## Claims

1. Finger-weighted surface wave filter having two finger-like reflector structures (11, 12) and a number of reflector fingers divided in their longitudinal direction into subfingers (112, 212), a subfinger (212) of a particular divided reflector finger (12) being in each case displaced relative to a principal direction of wave propagation as compared with the non-weighted position (12), characterized in that the finger-like reflector structures (11, 12) have reflector fingers (12, 13, 14, 112, 212) positioned at such a slant to the particular principal direction of wave propagation (6) that a kinked path (6, 7, 8) of the wave propagation arises between input and output (4, 5) (Figure 1), in that the division of a particular finger to be weighted (12) occurs at least once, and in that, relative to the principal direction of wave propagation (6) predetermined for the weighting displacement, these subfingers (112, 212) are in each case offset against one another by the measure corresponding to the predetermined weighting of the particular finger through parallel displacement opposed to their unweighted position (12).

2. Device according to Claim 1, characterized in that the offset corresponding to the weighting is parallel to that principal direction of wave propagation (6) which occurs before the wave reflection at the weighted finger concerned (12) (Figure 1 and 2).

3. Device according to Claim 1, characterized in that the offset corresponding to the weighting is parallel to the principal direction of wave propagation (8) which occurs after the wave reflection at the particular finger (12) (Figure 3).

4. Device according to Claim 1, characterized in that the offset corresponding to the weighting is partly parallel to that principal direction of wave propagation (6) which occurs before the wave reflection at the finger concerned (12), and is partly parallel to the principal direction of wave propagation (8) which occurs after the wave reflection at the finger concerned (12) (Figure 4).

5. Device according to one of Claims 1 to 4, characterized in that the neighbouring ends of the subfingers (112, 212) of individual weighted fingers (12) are connected with one another (312).

## Revendications

1. Filtre d'ondes de surface à pondération digitale, comportant des structures digitales réfléchissantes (11, 12) et un certain nombre de doigts réfléchissants subdivisés en doigts partiels (112, 212) dans leur direction longitudinale, un doigt partiel respectif (212) d'un doigt réfléchissant subdivisé (12) considéré étant décalé dans une direction de propagation principale des ondes par rapport à la position (12) non pondérée, caractérisé par le fait que les structures digitales réfléchissantes (11, 12) possèdent des doigts réfléchissants (12, 13, 14, 112, 212) disposés obliquement par rapport à la direction principale respective (6) de propagation des ondes, de sorte qu'on obtient un trajet coudé (6, 7, 8) de la propagation des ondes entre l'entrée et la sortie (4, 5) (figure 1), que la subdivision d'un doigt respectif (12) devant être pondéré est prévue au moins une fois, et que grâce à des décalages parallèles respectivement opposés, réalisés par rapport à leur position non pondérée (12) et rapportés à la direction principale (6) de propagation des ondes, prédéterminée pour le décalage de pondération, ces doigts partiels (112, 212) sont décalés entre eux d'une distance correspondant à la pondération prédéterminée du doigt considéré.

2. Composant suivant la revendication 1, caractérisé par le fait que le décalage correspondant à la pondération est parallèle à la direction principale (6) de propagation des ondes, qui est présente avant la réflexion des ondes sur le doigt pondéré (12) considéré (figures 1 et 2).

3. Composant suivant la revendication 1, caractérisé par le fait que le décalage correspondant à la pondération est parallèle à la direction principale (8) de propagation des ondes, qui est présente après la réflexion des ondes sur le doigt (12) considéré (figure 3).

4. Composant suivant la revendication 1, caractérisé par le fait que le décalage correspondant à la pondération est partiellement parallèle à la direction principale (6) de propagation des ondes, qui est présente avant la réflexion des ondes sur le doigt (12) considéré et est partiellement parallèle à la direction principale (8) de propagation des ondes qui est présente après la réflexion des ondes sur le doigt (12) considéré (figure 4).

5. Composant suivant l'une des revendications 2 à 4, caractérisé par le fait que les extrémités voisines des doigts partiels (112, 212) de doigts individuels pondérés (12) sont reliées entre elles (312).

# FIG 1

# FIG 2   FIG 3   FIG 4